# EUROPEAN PATENT SPECIFICATION

(11) **EP 2 747 532 B1**
(45) Date of publication and mention of the grant of the patent: **21.12.2016**
(21) Application number: 14160581.6
(22) Date of filing: 06.11.2006
(51) Int. Cl.: H05K 5/00, H05K 7/20

(54) **METHOD OF COOLING ELECTRONIC DEVICE AND ELECTRONIC DEVICE WITH IMPROVED COOLING EFFICIENCY**
VERFAHREN ZUR KÜHLUNG EINER ELEKTRONISCHEN VORRICHTUNG UND ELEKTRONISCHE VORRICHTUNG MIT ERHÖHTER KÜHLEFFIZIENZ
PROCEDE DE REFROIDISSEMENT DE DISPOSITIF ELECTRONIQUE ET DISPOSITIF ELECTRONIQUE A EFFICACITE DE REFROIDISSEMENT AMELIOREE

(30) Priority: 22.11.2005 KR 20050112008
(43) Date of publication of application: 25.06.2014
(62) Divisional of application: 06812424.7
(73) Proprietor: Samsung Electronics Co., Ltd., Suwon-si Gyeonggi-do 443-742 (KR)
(72) Inventor: Kim, Sung-Hyup, 443-727 Gyeonggi-do (KR); Lee, Sang-Jae, 443-727 Gyeonggi-do (KR); Kim, Sun-Soo, 441-863 Gyeonggi-do (KR)
(74) Representative: Birchenough, Lewis

(56) References cited:
- EP-A1- 1 360 884
- EP-A2- 1 122 991
- WO-A1-02/056659
- JP-A- H08 227 952
- JP-A- 2000 209 474
- US-A- 6 101 094
- US-A1- 2003 128 519
- US-A1- 2003 227 750
- US-A1- 2004 217 466

## Description

### BACKGROUND OF THE INVENTION

### 1. Field of the Invention

An aspect of the invention relates to a method of cooling an electronic device and an electronic device with improved cooling efficiency, and more particularly, to a method of efficiently cooling a portable compact electronic device that is difficult to cool and an electronic device that is difficult to cool with improved cooling efficiency.

### 2. Description of the Related Art

Portable electronic devices, such as camcorders, mobile phones, personal digital assistants (PDAs), portable multimedia players (PMPs), MP3 players, and notebook personal computers (PCs), have become smaller while being provided with more functions. Accordingly, an amount of heat generated by internal components of the electronic devices, such as a chipset, has increased. However, as electronic devices have become smaller, it has become more difficult to cool internal components of the electronic devices. There are known methods of cooling electronic devices using cooling fans, cooling fins, heat sinks, air intake vents, and the like. However, the inner space of a compact portable electronic device is so small that it is difficult to install a cooling device, such as a cooling fan, cooling fins, or a heat sink, in the small inner space. The use of such a cooling device would surely increase the overall size of the electronic device. Also, the method of naturally cooling an electronic device using an air intake vent through which ambient air enters has a limited ability to effectively cool the electronic device because the inner space of the electronic device is too small for effectively cooling.

Accordingly, various other attempts have been made to cool small portable electronic devices. For example, Korean Patent Application Publication No. 2005-61885 published on June 23, 2005, discloses a method of cooling a mobile phone terminal using heat absorbing/dissipating resins. US 2003/0227750A1 discloses a system for conducting heat away from an electrical component wherein the system has an elastically deformable member providing thermal communication with an electrical component. The deformable member is attached to a housing. US 2003/0227750A1 discloses an electronic device in accordance with the pre-characterizing portion of claim 7.

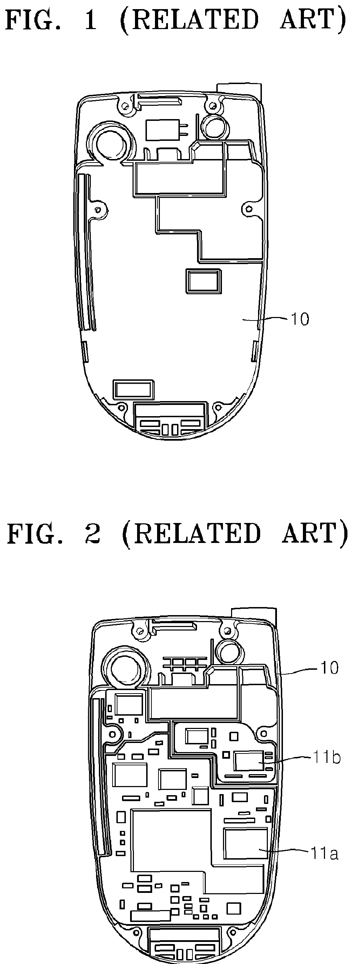

FIG. 1 shows a lower case 10 of the mobile phone terminal. Referring to FIG. 2, in the method referred to above, heat absorbing/dissipating resins 11a and 11b are injection-molded to conform to the shape of various components mounted on a printed circuit board (PCB) of the mobile phone terminal. These heat absorbing/dissipating resins 11a and 11b are attached to the lower case 10 shown in FIG. 1. Next, the PCB is fixedly attached to the heat absorbing/dissipating resins 11a and 11b. In this method, the surfaces of the heat absorbing/dissipating resins 11a and 11b must be molded to conform to the shape of the various components mounted on the PCB. Also, the heat absorbing/dissipating resins 11a and 11 b must be formed to conform to a plurality of sections defined in the lower case 10 of the mobile phone terminal.

As a result, if the design of the circuit or the case 10 is even slightly changed, the heat absorbing/dissipating resins 11a and 11b must be molded again. Accordingly, different heat absorbing/dissipating resins 11a and 11 b must be used for different products or different models, thereby increasing manufacturing costs and assembly time. Furthermore, even if the surfaces of the heat absorbing/dissipating resins 11a and 11b are very precisely molded, the various components mounted on the PCB may not perfectly contact the surfaces of the heat absorbing/dissipating resins 11 a and 11 b due to manufacturing tolerances, thereby deteriorating cooling efficiency. Furthermore, when numerous small components are mounted on the PCB, it is difficult to precisely mold the surfaces of the heat absorbing/dissipating resins 11a and 11b to conform to the shape of the small components, thereby making the assembly process complex.

### SUMMARY OF THE INVENTION

An aspect of the invention is a method of cooling an electronic device in a simple and efficient manner without the need to use different cooling members for different products or different models.

Another aspect of invention is an electronic device with improved cooling efficiency, which can be simply manufactured and assembled.

According to a first aspect of the invention, there is provided a method of cooling an electronic device, the electronic device comprising a case, a printed circuit board, and internal components, the method being as defined by claim 1.

Further second to sixth aspects of the invention are defined in the dependent claims 2 to 6, and according to another aspect of the invention , there is provided a method according to the first aspect, wherein the heat conductive filler is made of silicone rubber or foam resin.

According to a seventh aspect of the invention, there is provided an electronic device as defined in claim 7. Further eighth to twelve aspects of the invention are defined in dependent claims 8 to 12, and according to yet another aspect of the invention there is provided an electronic device wherein the heat conductive filler is made of silicone rubber or foam resin.

Additional aspects and/or advantages of the invention will be set forth in part in the description which follows and, in part, will be obvious from the description, or may be learned by practice of the invention.

### BRIEF DESCRIPTION OF THE DRAWINGS

The above and/or other aspects and advantages of the invention will become apparent and more readily appreciated from the following description of the embodiments, taken in conjunction with the accompanying drawings of which:
FIG. 1 is a plan view of a lower case of an electronic device to which heat absorbing/dissipating resins of the related art are to be attached;
FIG. 2 is a plan view of the heat absorbing/dissipating resins of the related art attached to the lower case of the electronic device shown in FIG. 1;
FIG. 3 is a perspective view of an electronic device to which an aspect of the invention is to be applied;
FIG. 4 is a perspective view showing the distribution of heat generated during the operation of the electronic device shown in FIG. 3;
FIGS. 5A through 5C are cross-sectional views showing heat conductive fillers inserted into the electronic device shown in FIG. 3 according to aspects of the invention;
FIG. 6 is an exploded perspective view showing heat conductive fillers inserted into the electronic device shown in FIG. 3 according to an aspect of the invention; and
FIGS. 7 and 8 are graphs for comparing the cooling effect achieved according to an aspect of the invention with the cooling effect achieved by other methods.

### DETAILED DESCRIPTION OF THE EMBODIMENTS

Reference will now be made in detail to embodiments of the invention, examples of which are shown in the accompanying drawings, wherein like reference numerals refer to like elements throughout. The embodiments are described below in order to explain the invention by referring to the figures.

Conventional methods have limitations in terms of dissipating heat generated by internal components of small portable electronic devices. To effectively cool internal components of an electronic device, a method according to an aspect of the invention inserts a heat conductive filler made of a material having elasticity and heat resistance, such as foam resin such as a sponge, or silicone rubber, into an empty space in the electronic device so that the heat conductive filler is in close contact with the internal components of the electronic device. Here, close contact refers to a state in which there is no space or substantially no space between a surface of the heat conductive filler and a surface of any internal component of the electronic device opposing the heat conductive filler. The cooling effect achieved by the heat conductive filler can be determined using temperature distribution data provided by a thermal flow analysis performed under various conditions.

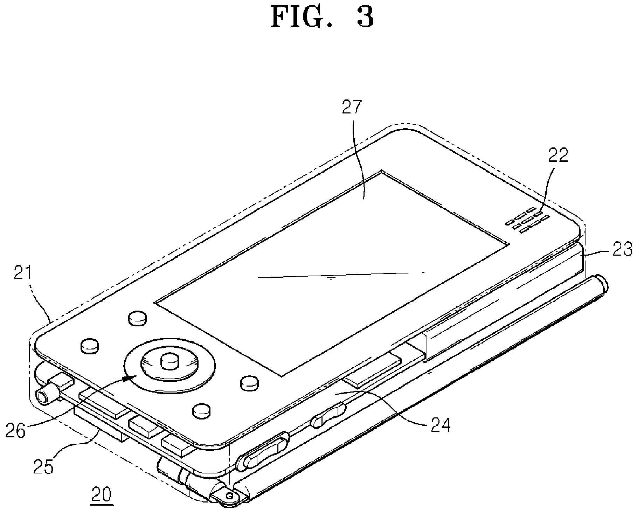

FIG. 3 is a perspective view of a portable multimedia player (PMP) 20 marketed under the brand name YM-P1 by the assignee of this application to which an aspect of the invention is to be applied. Referring to FIG. 3, the PMP 20 is configured in such a manner that a display panel 27, such as a liquid crystal display (LCD), a keypad 26, and a small speaker 22 are disposed on a top surface of a case 21. A printed circuit board (PCB) 24 on which various electronic components are mounted is fixedly installed in the case 21. A battery 23 is mounted on a side of the PCB 24, and a hard disk drive (HDD) 25 is disposed under the PCB 24.

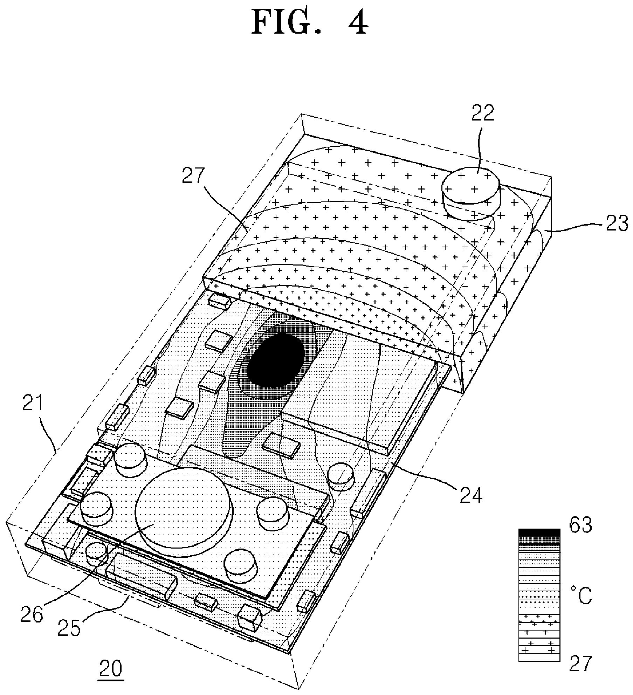

FIG. 4 is a perspective view showing the distribution of heat generated during the operation of the PMP 20 shown in FIG. 3 obtained by performing a thermal flow analysis in which temperature measurements at various locations in the PMP 20 are simulated. Referring to FIG. 4, when there is no cooling device in the PMP 20, the highest temperature at the center of the PCB 24 exceeds approximately 60°C.

An aspect of the invention employs a heat conductive filler having elasticity and heat resistance as a device for cooling heat-generating electronic components mounted on the PCB 24.

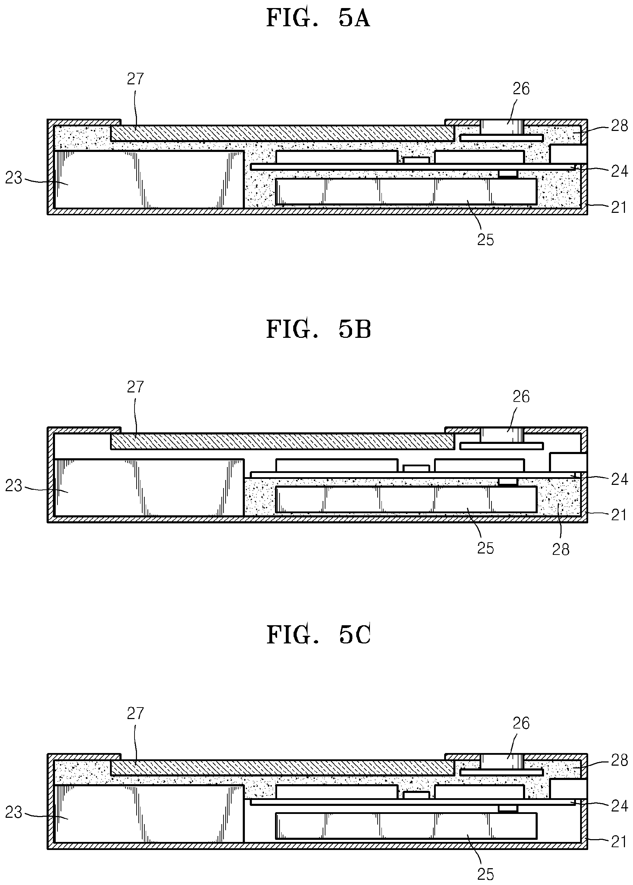

FIGS. 5A through 5C are cross-sectional views showing heat conductive fillers inserted into the PMP 20 shown in FIG. 3 according to aspects of the invention. A heat conductive filler 28 may be inserted into substantially the entire empty space in the PMP 20 as shown in FIG. 5A. When the heat-generating components are mounted only on a bottom surface of the PCB 24, the heat conductive filler 28 may be inserted only under the PCB 24 as shown in FIG. 5B. When the heat-generating components are mounted only on a top surface of the PCB 24, the heat conductive filler 28 may be inserted only above the PCB 24 as shown in FIG. 5C.

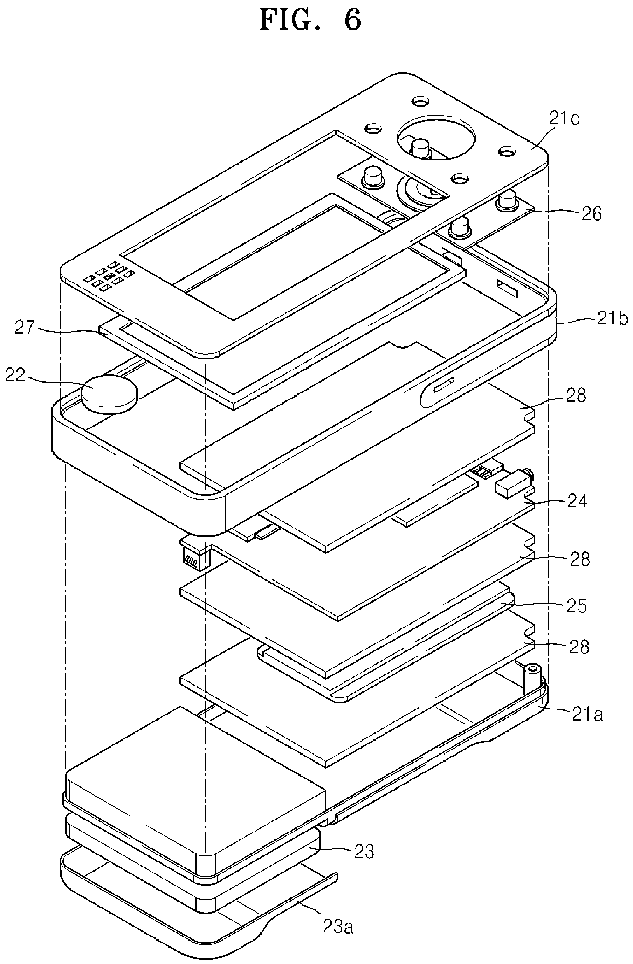

FIG. 6 is an exploded perspective view showing heat conductive fillers inserted into the PMP 20 shown in FIG. 3 according to an aspect of the invention. Referring to FIG. 6, substantially flat heat conductive fillers 28 having elasticity and heat resistance are inserted into substantially the entire empty space in the PMP 20. That is, the heat conductive fillers 28 having elasticity and heat resistance are disposed between the top surface of the PCB 24 and the display panel 27, between the bottom surface of the PCB 24 and the HDD 25, and between a lower case 21 a and the HDD 25. In this case, the thickness of each of the heat conductive fillers 28 when it is not compressed may be greater than the thickness of the space in which the heat conductive filler 28 is disposed after the assembly of the PMP 20. After the heat conductive fillers 28 have been disposed in this manner, the lower case 21a, a side case 21b, and an upper case 21 c are fixedly assembled together so that the heat conductive fillers 28 are compressed to be in close contact with the internal components of the PMP 20. For example, since the heat conductive filler 28 disposed between the top surface of the PCB 24 and the display panel 27 is compressed against the PCB 24 by the display panel 27 after the assembly of the PMP 20, the heat conductive filler 28 can be in close contact with electronic components mounted on the top surface of the PCB 24. In particular, since the heat conductive filler 28 has elasticity, the heat conductive filler 28 can uniformly contact all the electronic components mounted on the top surface of the PCB 24 irrespective of their height and size. Alternatively, but not according to the invention, the heat conductive filler 28 may be directly attached to an inner surface of the upper case 21 c and/or the lower case 21a before the assembly of the PMP 20. The reference numeral 23a in FIG. 6 denotes a battery case.

Although FIGS. 5A through 5C and FIG. 6 show the YM-P1 PMP 20 as the electronic device, the heat conductive filler 28 can be applied to other electronic devices, such as camcorders, mobile phones, personal digital assistants (PDAs), MP3 players, and notebook personal computers (PCs). Although the heat conductive filler 28 is in close contact with the entire area of the PCB 24 in FIGS. 5A through 5C and FIG. 6, the heat conductive filler 28 may be disposed to be in close contact with only a part of the entire area of the PCB 24 so as to be in close contact with only heat-generating components among the electronic components mounted on the PCB 24.

The heat conductive filler 28 may be made of a material having elasticity and heat resistance, and the thermal conductivity of the heat conductive filler 28 may be at least three times higher than that of air. In general, since the thermal conductivity of air is approximately 0.026 W/m-K at 1 atm and 27°C, the thermal conductivity of the heat conductive filler 28 may be at least approximately 0.08 W/m-K to ensure a cooling effect. Accordingly, the material of the heat conductive filler 28 may be foam resin such as a sponge, or more preferably, may be silicone rubber. Both the sponge and the silicone rubber have high elasticity and high heat resistance. Here, elasticity refers to an ability of the heat conductive filler 28 to be compressed by a force applied by a human and to return to an original shape after the force is removed. Such an elasticity enables the heat conductive filler 28 to conform to shapes of components of the PMP 20 without damaging those components when the heat conductive filler 28 is compressed against those components during assembly of the PMP 20. Also, heat resistance refers to an ability of the heat conductive filler 28 to withstand heat generated in the heat-generating electronic components during operation of the PMP 20, not an ability to withstand high temperature heat of many hundreds of degrees Celsius. For example, the heat resistance of the sponge may be about 100°C, and the heat resistance of the silicone rubber may be about 200°C. Also, since the thermal conductivity of the sponge is approximately 0.4 W/m-K and the thermal conductivity of the silicone rubber is approximately 2 W/m-K, both the sponge and the silicone rubber can satisfy the thermal conductivity conditions for the heat conductive filler 28.

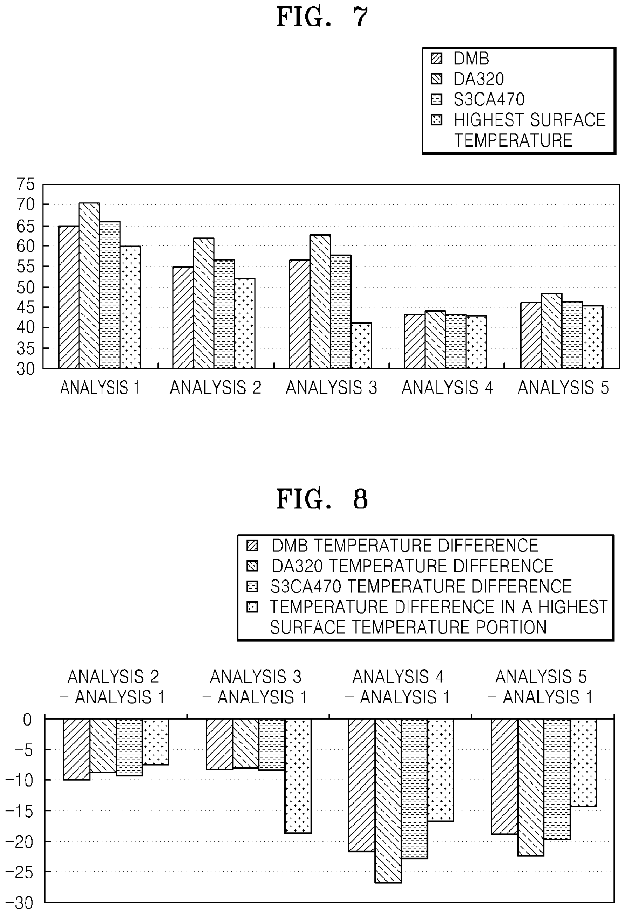

FIGS. 7 and 8 are graphs for comparing the cooling effect achieved according to an aspect of the invention and the cooling effect achieved by other methods. FIGS. 7 and 8 show results obtained after a thermal flow analysis was performed. The thermal flow analysis was performed on the PMP 20 shown in FIG. 3 using a 3D finite volume model under conditions of 1 atm and 27°C outside of the PMP 20. It was assumed that heat sources existing on the PCB 24 of the PMP 20 include only a digital multimedia broadcasting (DMB) chip, a DA320 chip, and an S3CA470 chip, which are standard chips used for DMB. There was a difference of approximately 8.8°C between results obtained from the thermal flow analysis performed using the model and results obtained by taking actual temperature measurements at various locations in the PMP 20. The graphs of FIGS. 7 and 8 were obtained after correcting for this difference.

Referring to FIGS. 7 and 8, analysis 1 is a case where no heat conductive filler 28 is inserted into the PMP 20 shown in FIG. 3. Analysis 2 is a case where no heat conductive filler is inserted into the PMP 20 and the upper case 21c is removed so that the inner heat sources can be in direct contact with ambient air. Analysis 3 is a case where no heat conductive filler is inserted into the PMP 20 and the material of the case 21 is aluminum instead of plastic. Analysis 4 is a case where a heat conductive filler made of silicone rubber is inserted into the PMP 20. Analysis 5 is a case where a heat conductive filler made of a sponge is inserted into the PMP 20.

Referring to FIG. 7, in the case of analysis 1, the temperatures of the heat sources, that is, the DMB chip, the DA320 chip, and the S3CA470 chip, in the PMP 20 reached approximately 65 to 70°C, and the surface temperature of the case 21 was approximately 60°C. In the case of analysis 2, the temperatures of the heat sources were approximately 55 to 62°C and the surface temperature of the case 21 was approximately 52°C, which is considered to be the lowest temperature obtainable by natural convection. In the case of analysis 3, the temperatures of the heat sources were similar to those of the heat sources in the case of analysis 2, but the surface temperature of the case 21 was approximately 41°C. In the case of analysis 4, both the temperatures of the heat sources and the surface temperature of the case 21 were approximately 43 to 44°C. In the case of analysis 5, both the temperatures of the heat sources and the surface temperature of the case 21 were approximately 45 to 48°C. When analysis 4 and analysis 5 are compared, although there is a great difference in thermal conductivity between the silicone rubber and the sponge, both analysis 4 and analysis 5 showed similar cooling effects.

FIG. 8 is a graph showing how much the temperatures of the heat sources and the surface temperature of the case 21 in the analyses 2 through 5 changed from those in analysis 1. Referring to FIG. 8, analysis 2 showed that the temperatures of the heat sources and the surface temperature of the case 21 dropped by approximately 10°C. Analysis 3 showed that the temperatures of the heat sources dropped by approximately 10°C and the surface temperature of the case 21 dropped by approximately 20°C. Analysis 4 showed that the temperatures of the heat sources dropped by approximately 22 to 26°C and the surface temperature of the case 21 dropped by approximately 16°C. Analysis 5 showed that the temperatures of the heat sources dropped by approximately 18 to 22°C and the surface temperature of the case 21 dropped by approximately 14°C.

Accordingly, when the heat conductive filler made of a sponge or silicone rubber is inserted into the empty space in the electronic device as shown in FIGS. 5A through 5C and FIG. 6, the electronic device can be simply cooled without increasing its size.

As described above, since the heat conductive filler made of a sponge or silicone rubber is inserted into the empty space of the electronic device, the electronic device can be simply and efficiently cooled without increasing its size. Furthermore, since the process of disposing the heat conductive filler having elasticity on the heat sources is simply added to the assembly of the electronic device, the assembly process is not complex. Moreover, since the surface of the heat conductive filler does not have to be molded to have a specific shape, different heat conductive fillers do not need to be used for different products or different models, thereby simplifying the manufacturing process and reducing manufacturing costs.

Although several embodiments of the invention have been shown and described, it would be appreciated by those skilled in the art that changes may be made in these embodiments without departing from the scope of the invention, which is defined by the accompanying claims.

## Claims

1. A method of cooling an electronic device (20), the electronic device comprising a case (21), a printed circuit board (24), and internal components mounted on the printed circuit board, the method comprising:
inserting, during assembly of the electronic device (20), a heat conductive filler (28) having elasticity and a substantially flat shape, into a space between the case (21) and one or more of the internal components, the heat conductive filler not being attached to the case;
wherein after the electronic device (20) has been assembled, the internal components, the printed circuit board (21) and the heat conductive filler (28) are disposed inside the case (21), and the heat conductive filler (28) is compressed to be in close contact with at least one of the internal components such that there is substantially no space between a surface of the heat conductive filler (28) and a surface of any internal component opposing the heat conductive filler;
wherein the heat conductive filler (28) is partially disposed between one surface of the case (21) and one or more of the internal components such that the heat conductive filler (28) is in direct contact with only at least one heat-generating internal component among all of the internal components once the electronic device (20) has been assembled, and wherein the heat conductive filler (28) is not moulded to a shape of the only at least one heat-generating internal component when disposed between the case (21) and the one or more internal components and not compressed.

2. The method of claim 1, wherein a thickness of the heat conductive filler (28) when the heat conductive filler (28) is not compressed is greater than a thickness of the space between the case (21) and the internal components.

3. The method of claim 1, wherein a thermal conductivity of the heat conductive filler (28) is at least three times higher than a thermal conductivity of air.

4. The method of claim 3, wherein the thermal conductivity of the heat conductive filler (28) is at least 0.08 W/m-K.

5. The method of claim 1, wherein the heat conductive filler (28) has a substantially flat shape when the heat conductive filler (28) is not compressed.

6. The method of claim 1, wherein the heat conductive filler (28) has a heat resistance that is sufficient to resist heat generated by the at least one heat-generating component during operation of the electronic device (20).

7. An electronic device (20) comprising:
a case (21);
a printed circuit board (24) inside the case (21);
internal components mounted on the printed circuit board (24); and
a heat conductive filler (28) having elasticity and a substantially flat shape, and being disposed between the case (21) and one or more of the internal components;
wherein the heat conductive filler (28) is compressed to be in close contact with at least one of the internal components such that there is substantially no space between a surface of the heat conductive filler (28) and a surface of any internal component opposing the heat conductive filler;
wherein the heat conductive filler (28) is partially disposed between one surface of the case (21) and one or more of the internal components such that the heat conductive filler (28) is in direct contact with only at least one heat-generating internal component among all of the internal components, and wherein the heat conductive filler (28) is not moulded to a shape of the only at least one heat-generating internal component when disposed between the case (21) and the one or more internal components and when not compressed,
**characterized in that** the heat conductive filler (28) is not attached to the case (21).

8. The electronic device (20) of claim 7, wherein a thickness of the heat conductive filler (28) when the heat conductive filler (28) is not compressed is greater than a thickness of the space between the case (21) and the internal components.

9. The electronic device (20) of claim 7, wherein a thermal conductivity of the heat conductive filler (28) is at least three times higher than a thermal conductivity of air.

10. The electronic device (20) of claim 9, wherein the thermal conductivity of the heat conductive filler (28) is at least 0.08 W/m-K.

11. The electronic device (20) of claim 7, wherein the heat conductive filler (28) has a substantially flat shape when the heat conductive filler (28) is not compressed.

12. The electronic device (20) of claim 7, wherein the heat conductive filler (28) has a heat resistance that is sufficient to resist heat generated by the at least one heat-generating component during operation of the electronic device (20).

## Patentansprüche

1. Verfahren zur Kühlung einer elektronischen Vorrichtung (20), wobei die elektronische Vorrichtung ein Gehäuse (21), eine Leiterplatte (24) und interne Komponenten umfasst, die auf der Leiterplatte montiert sind, wobei das Verfahren umfasst:
Einfügen, während der Montage der elektronischen Vorrichtung (20), eines wärmeleitfähigen Füllstoffs (28), der Elastizität und eine im Wesentlichen flache Form aufweist, in einen Raum zwischen dem Gehäuse (21) und einem oder mehr der internen Bestandteile, wobei der wärmeleitfähige Füllstoff nicht am Gehäuse befestigt ist;
wobei nach dem die elektronische Vorrichtung (20) montiert worden ist, die inneren Bestandteile, die Leiterplatte (21) und der wärmeleitfähige Füllstoff (28) innerhalb des Gehäuses (21) angeordnet werden, und der wärmeleitfähige Füllstoff (28) wird komprimiert, um in engem Kontakt mit wenigstens einem der internen Bestandteile zu sein, derart, dass es im Wesentlichen keinen Raum zwischen einer Oberfläche des wärmeleitfähigen Füllstoffs (28) und einer Oberfläche irgendeines internen Bestandteils gibt, das dem wärmeleitfähigen Füllstoff entgegengesetzt ist;
wobei der wärmeleitfähige Füllstoff (28) teilweise zwischen einer Oberfläche des Gehäuses (21) und einem oder mehr der internen Bestandteile angeordnet ist, derart, dass der wärmeleitfähige Füllstoff (28) in direktem Kontakt mit nur wenigstens einem Wärme erzeugenden internen Bestandteil unter all den internen Bestandteilen ist, sobald die elektronische Vorrichtung (20) montiert worden ist, und wobei der wärmeleitfähige Füllstoff (28) nicht zu einer Form des nur wenigstens einen Wärme erzeugenden internen Bestandteils geformt wird, wenn er zwischen dem Gehäuse (21) und dem einen oder mehr internen Bestandteilen angeordnet und nicht komprimiert angeordnet ist.

2. Verfahren nach Anspruch 1, wobei eine Dicke des wärmeleitfähigen Füllstoffs (28), wenn der wärmeleitende Füllstoff (28) nicht komprimiert ist, größer als eine Dicke des Raums zwischen dem Gehäuse (21) und den internen Bestandteilen ist.

3. Verfahren nach Anspruch 1, wobei eine Wärmeleitfähigkeit des wärmeleitfähigen Füllstoffs (28) wenigstens dreimal höher als eine Wärmeleitfähigkeit von Luft ist.

4. Verfahren nach Anspruch 3, wobei die Wärmeleitfähigkeit des wärmeleitfähigen Füllstoffs (28) wenigstens 0,08 W/m-K beträgt.

5. Verfahren nach Anspruch 1, wobei der wärmeleitfähige Füllstoff (28) eine im Wesentlichen flache Form aufweist, wenn der wärmeleitfähige Füllstoff (28) nicht komprimiert ist.

6. Verfahren nach Anspruch 1, wobei der wärmeleitfähige Füllstoff (28) eine Wärmebeständigkeit aufweist, die ausreichend ist, um Wärme zu widerstehen, die vom wenigstens einen Wärme erzeugenden Bestandteil während des Betriebs der elektronischen Vorrichtung (20) erzeugt wird.

7. Elektronische Vorrichtung (20), umfassend:
Ein Gehäuse (21);
eine Leiterplatte (24) im Innern des Gehäuses (21);
interne Bestandteile, die auf der Leiterplatte (24) montiert sind; und
einen wärmeleitfähigen Füllstoff (28), der Elastizität und eine im Wesentlichen flache Form aufweist, und zwischen dem Gehäuse (21) und einem oder mehr internen Bestandteilen angeordnet ist;
wobei der wärmeleitfähige Füllstoff (28) komprimiert wird, um in engem Kontakt mit wenigstens einem der internen Bestandteile zu sein, derart, dass es im Wesentlichen keinen Raum zwischen einer Oberfläche des wärmeleitfähigen Füllstoffs (28) und einer Oberfläche irgendeines internen Bestandteils gibt, das dem wärmeleitfähigen Füllstoff entgegengesetzt ist;
wobei der wärmeleitfähige Füllstoff (28) teilweise zwischen einer Oberfläche des Gehäuses (21) und einem oder mehr der internen Bestandteile angeordnet ist, derart, dass der wärmeleitfähige Füllstoff (28) in direktem Kontakt mit nur wenigstens einem Wärme erzeugenden internen Bestandteil unter all den internen Bestandteilen ist, und wobei der wärmeleitfähige Füllstoff (28) nicht zu einer Form des nur wenigstens einen Wärme erzeugenden internen Bestandteils geformt wird, wenn er zwischen dem Gehäuse (21) dem einen oder mehr internen Bestandteilen und nicht komprimiert angeordnet ist,
**dadurch gekennzeichnet, dass** der wärmeleitfähige Füllstoff (28) nicht am Gehäuse (21) befestigt ist.

8. Elektronische Vorrichtung (20) nach Anspruch 7, wobei eine Dicke des wärmeleitfähigen Füllstoffs (28), wenn der wärmeleitende Füllstoff (28) nicht komprimiert ist, größer als eine Dicke des Raums zwischen dem Gehäuse (21) und den internen Bestandteilen ist.

9. Elektronische Vorrichtung (20) nach Anspruch 7, wobei eine Wärmeleitfähigkeit des wärmeleitfähigen Füllstoffs (28) wenigstens dreimal höher als eine Wärmeleitfähigkeit von Luft ist.

10. Elektronische Vorrichtung (20) nach Anspruch 9, wobei die Wärmeleitfähigkeit des wärmeleitfähigen Füllstoffs (28) wenigstens 0,08 W/m-K beträgt.

11. Elektronische Vorrichtung (20) nach Anspruch 7, wobei der wärmeleitfähige Füllstoff (28) eine im Wesentlichen flache Form aufweist, wenn der wärmeleitfähige Füllstoff (28) nicht komprimiert ist.

12. Elektronische Vorrichtung (20) nach Anspruch 7, wobei der wärmeleitfähige Füllstoff (28) eine Wärmebeständigkeit aufweist, die ausreichend ist, um Wärme zu widerstehen, die vom wenigstens einen Wärme erzeugenden Bestandteil während des Betriebs der elektronischen Vorrichtung (20) erzeugt wird.

## Revendications

1. Un procédé de refroidissement d'un dispositif électronique (20), le dispositif électronique comprenant un boîtier (21), une carte à circuits imprimés (24) et des composants internes montés sur la carte à circuits imprimés, le procédé comprenant :
l'insertion, au cours de l'assemblage du dispositif électronique (20), d'une charge thermoconductrice (28) possédant une élasticité et une forme sensiblement plane, dans un espace entre le boîtier (21) et un ou plusieurs des composants internes, la charge thermoconductrice n'étant pas rattachée au boîtier,
où, une fois que le dispositif électronique (20) a été assemblé, les composants internes, la carte à circuits imprimés (21) et la charge thermoconductrice (28) sont disposés à l'intérieur du boîtier (21), et la charge thermoconductrice (28) est comprimée de façon à être en contact étroit avec au moins un des composants internes de sorte qu'il n'existe sensiblement aucun espace entre une surface de la charge thermoconductrice (28) et une surface de tout composant interne opposé à la charge thermoconductrice,
où la charge thermoconductrice (28) est partiellement disposée entre une surface du boîtier (21) et un ou plusieurs des composants internes de sorte que la charge thermoconductrice (28) soit en contact direct avec seulement au moins un composant interne thermogène parmi la totalité des composants internes une fois que le dispositif électronique (20) a été assemblé, et où la charge thermoconductrice (28) n'est pas moulée selon une forme du seulement au moins un composant interne thermogène lorsqu'elle est disposée entre le boîtier (21) et les un ou plusieurs composants internes et non comprimée.

2. Le procédé selon la Revendication 1, où une épaisseur de la charge thermoconductrice (28) lorsque la charge thermoconductrice (28) n'est pas comprimée est supérieure à une épaisseur de l'espace entre le boîtier (21) et les composants internes.

3. Le procédé selon la Revendication 1, où une conductivité thermique de la charge thermoconductrice (28) est au moins trois fois plus élevée qu'une conductivité thermique de l'air.

4. Le procédé selon la Revendication 3, où la conductivité thermique de la charge thermoconductrice (28) est au moins de 0,08 W/m-K.

5. Le procédé selon la Revendication 1, où la charge thermoconductrice (28) possède une forme sensiblement plane lorsque la charge thermoconductrice (28) n'est pas comprimée.

6. Le procédé selon la Revendication 1, où la charge thermoconductrice (28) possède une résistance à la chaleur qui est suffisante pour résister à une chaleur générée par le au moins un composant thermogène au cours du fonctionnement du dispositif électronique (20).

7. Un dispositif électronique (20) comprenant :
un boîtier (21),
une carte à circuits imprimés (24) à l'intérieur du boîtier (21),
des composants internes montés sur la carte à circuits imprimés (24), et
une charge thermoconductrice (28) possédant une élasticité et une forme sensiblement plane et qui est disposée entre le boîtier (21) et un ou plusieurs des composants internes,
où la charge thermoconductrice (28) est comprimée de façon à être en contact étroit avec au moins un des composants internes de sorte qu'il n'existe sensiblement aucun espace entre une surface de la charge thermoconductrice (28) et une surface de tout composant interne opposé à la charge thermoconductrice,
où la charge thermoconductrice (28) est partiellement disposée entre une surface du boîtier (21) et un ou plusieurs des composants internes de sorte que la charge thermoconductrice (28) soit en contact direct avec seulement au moins un composant interne thermogène parmi la totalité des composants internes, et où la charge thermoconductrice (28) n'est pas moulée selon une forme du seulement au moins un composant interne thermogène lorsqu'elle est disposée entre le boîtier (21) et les un ou plusieurs composants internes et lorsqu'elle n'est pas comprimée,
**caractérisé en ce que** la charge thermoconductrice (28) n'est pas rattachée au boîtier (21).

8. Le dispositif électronique (20) selon la Revendication 7, où une épaisseur de la charge thermoconductrice (28) lorsque la charge thermoconductrice (28) n'est pas comprimée est supérieure à une épaisseur de l'espace entre le boîtier (21) et les composants internes.

9. Le dispositif électronique (20) selon la Revendication 7, où une conductivité thermique de la charge thermoconductrice (28) est au moins trois fois plus élevée qu'une conductivité thermique de l'air.

10. Le dispositif électronique (20) selon la Revendication 9, où la conductivité thermique de la charge thermoconductrice (28) est au moins de 0,08 W/m-K.

11. Le dispositif électronique (20) selon la Revendication 7, où la charge thermoconductrice (28) possède une forme sensiblement plane lorsque la charge thermoconductrice (28) n'est pas comprimée.

12. Le dispositif électronique (20) selon la Revendication 7, où la charge thermoconductrice (28) possède une résistance à la chaleur qui est suffisante pour résister à une chaleur générée par le au moins un composant thermogène au cours du fonctionnement du dispositif électronique (20).
